# EUROPEAN PATENT APPLICATION

(11) **EP 1 832 641 A1**
(43) Date of publication of application: **12.09.2007**
(21) Application number: 05811527.0
(22) Date of filing: 28.11.2005
(51) Int. Cl.: C09K 11/59, H01J 61/44

(54) **PHOSPHOR AND ULTRAVIOLET RAY EXCITED LUMINESCENT ELEMENT**

(30) Priority: 30.11.2004 JP 2004345720
(71) Applicant: Sumitomo Chemical Company, Limited, Tokyo 104-8260 (JP)
(72) Inventor: NAKAMURA, Yoshiko, 3050821 (JP); ISOBE, Toshinori, 3050821 (JP); KUZE, Satoru, 3050821 (JP); MIYAZAKI, Susumu, 3001525 (JP)
(74) Representative: Lips, Hendrik Jan George
(86) International application number: PCT/JP2005/022229
(87) International publication number: WO 2006/059738

(57) **Abstract**

The present invention provides a phosphor and an ultraviolet excited light-emitting device. The phosphor comprises a compound represented by the formula (I): Ca_{1-b-c}Sr_{b}Eu_{c}MgSi₂O₆ (I) wherein 0.5<b<1, and 0<c ≦ 0.1. The ultraviolet excited light-emitting device comprises the above phosphor.

## Description

### TECHNICAL FIELD

The present invention relates to a phosphor which exhibits high brightness and an ultraviolet excited light-emitting device.

### BACKGROUND ART

Phosphors are used for backlights of liquid crystal displays and ultraviolet excited light-emitting devices such as three-wavelength fluorescent lamps. The ultraviolet ray is a light having a wavelength of about 200 nm to about 400 nm, for example, being represented by a mercury bright line having the wavelength of 254 nm. As a phosphor for such ultraviolet excited light-emitting devices, for example, CaMgSi₂O₆:Eu is proposed (JP 2002-285147), however, in view of enhancing the performance of the ultraviolet excited light-emitting devices, a phosphor exhibiting much higher brightness is currently desired.

### DISCLOSURE OF THE INVENTION

An object of the present invention is to provide a phosphor and ultraviolet excited light-emitting device exhibiting high brightness.

The present inventors have diligently studied about phosphors to solve the problems mentioned above, and completed the present invention.

That is, the present invention provides a phosphor comprising a compound represented by the formula (I)

Ca_{1-b-c}Sr_{b}Eu_{c}MgSi₂O₆ (I)

wherein 0.5<b<1, and 0<c≦0.1.

The present invention also provides an ultraviolet excited light-emitting device comprising the above phosphor.

### MODE OF CARRYING OUT THE INVENTION

### [Phosphor]

The phosphor of the present invention includes the compound represented by the above formula (I).

In the formula (I), b is more than 0.5, preferably 0.55 or more, and more preferably 0.60 or more; and being less than 1, preferably 0.9 or less, and more preferably 0.7 or less.

Furthermore, c is more than 0, preferably more than 0.003, and more preferably 0.005 or more; and being 0.05 or less, and preferably 0.04 or less.

Examples of the above compound include Ca_{0.392}Sr_{0.6}Eu_{0.008}MgSi₂O_{6,} Ca_{0.342}Sr_{0.65}Eu_{0.008}MgSi₂O_{6,} Ca_{0.38}Sr_{0.6}Eu_{0.02}MgSi₂O_{6,} and Ca_{0.36}Sr_{0.6}Eu_{0.04}MgSi₂O₆. A composition thereof may be determined with a fluorescent x-ray analysis.

The phosphor is usually in the form of particle, and has an average particle diameter thereof is preferred to be larger in view of enhancing the brightness of the phosphor, for example, the average particle diameter is preferably 0.5 µm or more. On the other hand, an upper limit of the average particle diameter is usually 15 µm, preferably 8 µm, and more preferably 5 µm.

Since the phosphor is excited under irradiation of ultraviolet ray (for example, a wavelength of about 200 nm to about 400 nm) to emit blue light having high brightness, it is used as an ultraviolet excited light-emitting device. Furthermore, the phosphor emits blue light having high brightness at 100°C as well as does at 25°C, it is suitably used as an ultraviolet light-emitting device having a high output.

The above phosphor, for example, may be prepared by calcining a mixture of metal compounds which is converted to the compound represented by the above formula (I) by calcination.

Examples of the metal compounds include calcium compound, strontium compound, europium compound, magnesium compound, and silicon compound.

The calcium compound is a compound such as hydroxide, carbonate, nitrate, halide and oxalate having a purity of 99 % or more, which is converted to an oxide by decomposing at a high temperature; or is an oxide having a purity of 99.9 % or more.

The strontium compound is a compound such as hydroxide, carbonate, nitrate, halide and oxalate having a purity of 99 % or more, which is converted decomposing at a high temperature; or is an oxide having a purity of 99.9 % or more.

The europium compound is a compound such as hydroxide, carbonate, nitrate, halide and oxalate having a purity of 99 % or more, which is converted to an oxide by decomposing at a high temperature; or is an oxide having a purity of 99 % or more.

The magnesium compound is a compound such as hydroxide, carbonate, nitrate, halide and oxalate having a purity of 99 % or more, which is converted to an oxide by decomposing at a high temperature; is an oxide having a purity of 99 % or more.

The silicon compound is a compound such as hydroxide, carbonate, nitrate, halide and oxalate having a purity of 99 % or more, which is converted to an oxide by decomposing at a high temperature; or is an oxide having a purity of 99 % or more.

Furthermore, the metal compound may be a complex salt containing at least two compounds selected from calcium compound, strontium compound, europium compound, magnesium compound, and silicon compound.

Mixing the metal compounds, for example, may be conducted with a ball mill, V-shape blender, or agitator. The metal compounds are usually weighed and mixed to obtain an mixture in a molar ratio of Ca:Sr:Eu:Mg:Si satisfies 1-b-c:b:c:1:2 [0.5<b<1, and 0<c≦0.1].

Calcination, for example, may be conducted under conditions at 1000°C or more, and preferably 1100°C or more; and 1500°C or less, and preferably 1200°C or less; and for 0.3 hours or more, and preferably 1 hour or more; and 100 hours or less, and preferably 10 hours or less. The calcination may be conducted under an inert gas atmosphere such as nitrogen and argon; an oxidative atmosphere such as air, oxygen, oxygen-containing nitrogen, or oxygen-containing argon; or a reductive atmosphere such as nitrogen containing hydrogen 0.1 to 10% by volume and argon containing hydrogen 0.1 to 10% by volume; and preferably under a reductive atmosphere. Furthermore, before calcination, the mixture of the metal compounds may be added with an appropriate amount of carbon. With the addition of the carbon, the calcination is carried out under stronger reductive atmosphere. To enhance a crystallinity of the phosphor, the mixture of the metal compounds may be added with an appropriate amount of flux before calcination. Examples of the flux include LiF, NaF, KF, LiCl, NaCl, KCl, Li₂CO₃, Na₂CO₃, K₂CO₃, NaHCO₃, NH₄F·HF, NH₄Cl, and NH₉I. The calcination may be conducted twice or more.

When the metal compound is a compound such as hydroxides, carbonates, nitrates, halides and oxalates which is converted to an oxide by decomposing at a high temperature, the metal compound may be pre-calcined before calcination. The pre-calcination may be conducted under conditions of converting the metal compound to oxide thereof or of removing chemically combined water from the metal compound, for example, may be conducted by maintaining at a temperature of 400°C or more and less than 1000°C. The pre-calcination may be conducted under any of an inert gas atmosphere, an oxidative atmosphere such as an ambient atmosphere, and a reductive atmosphere.

The obtained calcined substance may be ground or washed and classified. By grinding and classifying, a phosphor having a controlled particle distribution is obtained. The grinding, for example, may be conducted with a ball mill or jet mill.

### [Ultraviolet excited light-emitting device]

The ultraviolet excited light-emitting device of the present invention includes the above phosphor, and usually includes the phosphor and electrodes. Examples of the ultraviolet excited light-emitting device include three-wavelength fluorescent lamp and backlight for liquid crystal display. The three-wavelength fluorescent lamp may be fabricated according to the method disclosed in JP 2004-2569, and the method includes the steps of (i) to (vii):
(i) weighing a red light-emitting phosphor, a green light-emitting phosphor, and the above blue light-emitting phosphor with the proviso that the color required as an emission color of a light-emitting device (for example, white) is provided, and mixing such phosphors with a solvent (for example, aqueous polyethylene oxide solution) to obtain a coating solution;
(ii) coating the coating solution on an inner face of a glass bulb;
(iii) baking the glass bulb at about 400°C to about 900°C to form a fluorescent film;
(iv) mounting and sealing electrodes at ends of the glass bulb;
(v) exhausting the inside of the bulb and enclosing mercury and a rare gas therein;
(vi) sealing the exhaust pipe; and
(vii) mounting caps.

The red light-emitting phosphor may emit red under ultraviolet irradiation. Examples of red light-emitting phosphor include a compound containing trivalent europium-activated yttrium oxide (Y₂O₃: Eu) or trivalent europium-activated yttrium oxysulfide (Y₂O₂S:Eu).

The green light-emitting phosphor may emit green under ultraviolet irradiation. Examples of green light-emitting phosphor a compound containing cerium- and terbium-activated lanthanum phosphate (LaPO₄:Ce,Tb), or terbium-activated cerium·terbium·magnesium·aluminate ((CeTb) MgAl₁₁O₁₉:Tb).

The blue light-emitting phosphor may be a compound containing the compound represented by the above formula (I) . The blue light-emitting phosphor may contain other compound than the above formula (I). The other compound may be a compound emitting blue under ultraviolet irradiation.
Examples of the other compound include
europium-activated strontium phosphate chloride Sr₅(PO₄)₃Cl:Eu, europium-activated strontium·barium·calcium phosphate chloride (Sr, Ca, Ba)₅(PO₉)₃Cl:Eu, and
europium-activated barium·magnesium·aluminate BaMg₂Al₁₆O₂₇:Eu and BaMgAl₁₀O₁₇ : Eu .

An ultraviolet excited light-emitting device other than the three-wavelength fluorescent lamp (for example, backlight for liquid crystal display) is fabricated using the above phosphor with the same manner according to the method disclosed in JP 2005-068403.

### EXAMPLES

The invention will be explained in more detail according to Examples, but the invention should not be construed to be limited thereto.

### Average Particle diameter (µm):

A sample was photographed with a scanning electron microscope to obtain a photo image, 50 particles in the photo image were analyzed with an intercept method to obtain particle diameters, and then an average value was calculated from the particle diameters. The average value was defined as an average particle diameter.

### Chromaticity x and y

Chromaticity x and y were measured according to the CIE-XYZ color system provided by CIE(Commission Internationale de l'Eclairage).

### Reference 1

Calcium carbonate (CaCO_{3,} manufactured by Ube Material Industries, Ltd., trade name "Super-high purity calcium carbonate CS·3N-A"), europium oxide(Eu₂O₃, manufactured by Shin-Etsu Chemical Co., Ltd.), magnesium carbonate (MgCO₃, manufactured by Kyowa Chemical Industry Co., Ltd., trade name "High purity magnesium carbonate", MgO content: 42.0%), and silicon dioxide (SiO₂ manufactured by NIHON Aerosil K.K., trade name "AEROSIL200") were weighed and mixed to obtain a mixture in which the molar ratio of Ca:Eu:Mg:Si was 0.992:0.008:1:2. The operation of maintaining the mixture at 1200°C for 2 hours under 2 vol% H₂ containing N₂ atmosphere and then cooling was repeated totally 3 times to obtain a phosphor containing Ca_{0.992}Eu_{0.008}MgSi₂O₆.

The composition and average particle diameter of the phosphor were shown in Table 1. The phosphor was irradiated with ultraviolet (mercury bright line having a wavelength of 254 nm) at 25°C and 100°C to measure the brightness. The result was shown in Table 2. The chromaticity of the phosphor was also shown in Table 2.

The brightness at 25°C was represented by assuming the brightness of Reference 1 at 25°C to be 100, and the brightness at 100°C was represented by assuming the brightness of Reference 1 at 100°C to be 100.

### Reference 2

Except that the molar ratio of Ca:Sr:Eu:Mg:Si was changed to 0.49:0.49:0.02:1:2, the operation was carried out in the same manner as in Reference 1 to obtain a phosphor containing Ca_{0.49}Sr_{0.49}Eu_{0.02}MgSi₂O₆. The composition and average particle diameter of the phosphor were shown in Table 1. The brightness and chromaticity thereof were shown in Table 2.

### Example 1

Calcium carbonate (CaCO₃, manufactured by Ube Material Industries, Ltd., trade name "Super-high purity calcium carbonate CS·3N-A"), strontium carbonate (SrC0₃, manufactured by Sakai Chemical Industry Co., Ltd., trade name "High purity strontium carbonate SW-K"), europium oxide (Eu₂O₃, manufactured by Shin-Etsu Chemical Co., Ltd.), magnesium carbonate (MgCO₃, manufactured by Kyowa Chemical Industry Co., Ltd., trade name "High purity magnesium carbonate", MgO content: 42.0%), and silicon dioxide (SiO₂, manufactured by NIHON Aerosil K.K., trade name "AEROSIL200") were weighed and mixed to obtain a mixture in which the molar ratio of Ca:Sr:Eu:Mg:Si is 0.392:0.6:0.008:1:2. The operation of maintaining the mixture at 1150°C for 2 hours under 2 vol% H₂ containing N₂ atmosphere and then cooling was repeated totally 2 times to obtain a phosphor containing Ca_{0.392}Sr_{0.6}Eu_{0.008}MgSi₂O₆. The composition and average particle diameter of the phosphor were shown in Table 1. The brightness and chromaticity thereof were shown in Table 2.

### Example 2

Except that the molar ratio of Ca:Sr:Eu:Mg:Si was changed to 0.342: 0. 65: 0.008 : 1 : 2, the operation was carried out in the same manner as in Example 1 to obtain a phosphor containing Ca_{0.342}Sr_{0.65}Eu_{0.008}MgSi₂O₆. The composition and average particle diameter of the phosphor were shown in Table 1. The brightness and chromaticity thereof were shown in Table 2.

### INDUSTRIAL APPLICABILITY

According to the present invention, provided is a phosphor which exhibits high brightness under ultraviolet irradiation. Furthermore, according to the invention, provided is an ultraviolet excited light-emitting device exhibiting high brightness.

**Table 1 COMPOSITION AND AVERAGE PARTICLE DIAMETER OF PHOSPHOR**

| | Composition | Average Particle Diameter (µm) |
|---|---|---|
| Reference 1 | Ca_{0.992}Eu_{0.008}MgSi₂O₆ | 0.4 |
| Reference 2 | Ca_{0.49}Sr_{0.49}Eu_{0.02}MgSi₂O₆ | 0.8 |
| Example 1 | Ca_{0.392}Sr_{0.6}Eu_{0.008}MgSi₂O₆ | 1.0 |
| Example 2 | Ca_{0.342}Sr_{0.65}Eu_{0.008}MgSi₂O₆ | 1.0 |

**TABLE 2 EMISSION CHARACTERISTICS OF PHOSPHOR**

| | Emission Color | 25°C | | | 100°C | | |
|---|---|---|---|---|---|---|---|
| | | Brightness | Chromaticit x | Chromaticit y | Brightness | Chromaticit x | Chromaticit y |
| Reference 1 | Blue | 100 | 0.155 | 0.045 | 100 | 0.165 | 0.058 |
| Reference 2 | Blue | 241 | 0.156 | 0.035 | 438 | 0.156 | 0.037 |
| Example 1 | Blue | 256 | 0.156 | 0.034 | 490 | 0.156 | 0.035 |
| Example 2 | Blue | 249 | 0.156 | 0.034 | 476 | 0.156 | 0.035 |

## Claims

1. A phosphor comprising a compound represented by the formula (I) :
Ca_{1-b-c}Sr_{b}Eu_{c}MgSi₂O₆ (I)
wherein 0.5<b<1, and 0<c≦0.1.

2. The phosphor according to claim 1, wherein b is 0.55 or more.

3. The phosphor according to claim 1, wherein c is more than 0. 003.

4. The phosphor according to claim 1, wherein the phosphor is in the form of particle and has an average particle diameter of 0.5 µm or more.

5. An ultraviolet excited light-emitting device comprising the phosphor according to any one of claims 1 to 4.

6. A use of the phosphor according to any one of Claims 1 to 4 as an ultraviolet excited light-emitting device.
